# EUROPEAN PATENT APPLICATION

(11) **EP 3 525 220 A1**
(43) Date of publication of application: **14.08.2019**
(21) Application number: 17858617.8
(22) Date of filing: 08.09.2017
(51) Int. Cl.: H01F 41/04, H05K 9/00, H02J 7/02, H02J 50/10

(54) **COIL BLOCK FOR WIRELESS CHARGING AND METHOD FOR MANUFACTURING SAME**

(30) Priority: 06.10.2016 KR 20160129191
(71) Applicant: LG Innotek Co., Ltd., Seoul 04637 (KR)
(72) Inventor: PARK, Yu Ri, Seoul 04637 (KR); LEE, Young Kyu, Seoul 04637 (KR); LEEM, Sung Hyun, Seoul 04637 (KR)
(74) Representative: DREISS Patentanwälte PartG mbB
(86) International application number: PCT/KR2017/009848
(87) International publication number: WO 2018/066822

(57) **Abstract**

The present invention relates to a coil block for wireless charging, a wireless charging device equipped with the corresponding coil block, and a method for manufacturing the same. A method for manufacturing a coil block for wireless charging according to an embodiment of the present invention may comprise the steps of: configuring a shielding block comprising two lead holes to be penetrated by two lead wires configured on a pattern coil; arranging the pattern coil on a surface of the shielding block by causing respective lead wires to penetrate the corresponding lead holes; and attaching an adhesive member to another surface of the shielding block. Therefore, the present invention can advantageously provide a coil block that can be manufactured at a low cost and has excellent durability, and a wireless charging device equipped with the corresponding coil block.

## Description

### [Technical Field]

Embodiments relate to wireless charging technology, and more particularly, to a coil block for wireless charging for reducing costs and maximizing process efficiency, a wireless charging apparatus with the coil block installed therein, and a method of manufacturing the coil block and the apparatus.

### [Background Art]

Wireless power transmission or wireless energy transfer technology refers to technology of wirelessly transmitting electric energy from a transmitter to a receiver using the principle of magnetic induction. In the 1800s, electrical motors or transformers using the principle of electromagnetic induction already started to be used and then a method of radiating radio waves or electromagnetic waves such as lasers and transmitting electric energy were also attempted. Commonly used electric toothbrushes or electric razors are charged using the principle of electromagnetic induction.

Up to now, a wireless energy transfer method may be roughly divided into a magnetic induction method, an electromagnetic resonance method and a power transmission method using a short-wavelength radio frequency.

The magnetic induction method refers to technology of using a phenomenon that, when two coils are adjacently placed and current is supplied to one coil, a magnetic flux is generated to generate electromotive force in the other coil, and is commercially available in small apparatuses such as mobile phones. The magnetic induction method may transmit power of a maximum of several kilowatts (kW) and has high efficiency. However, since a maximum transmission distance is 1 cm or less, an apparatus should be generally located to be adjacent to a charger.

The magnetic induction method uses an electric field or a magnetic field instead of electromagnetic waves or current. The magnetic induction method is hardly influenced by an electromagnetic wave and thus is harmless to other electronic apparatuses and humans. In contrast, the magnetic induction method may be used at a limited distance and in a limited space and energy transfer efficiency is slightly low.

The short-wavelength wireless power transmission method - briefly referred to as an RF method - uses a method of directly transmitting and receiving energy in the form of radio waves. This technology is an RF type wireless power transmission method using a rectenna. Rectenna means is a compound word of "antenna" and "rectifier" and means an element for directly converting RF power into direct current (DC) power. That is, the RF method is technology of converting AC radio waves into DC radio waves and using DC radio waves and, recently, research into commercialization thereof has been actively conducted as efficiency is improved.

Wireless power transmission technology may be variously used in IT, railroad and consumer-electronics in addition to the mobile industry.

In general, a wireless power transmission apparatus includes a coil for wireless power transmission, hereinafter referred to as a transmission coil, and a wireless power reception apparatus includes a coil for wireless power reception, hereinafter, referred to as a reception coil.

In addition, the wireless power transmission apparatus and the wireless power reception apparatus use a shielding material for blocking transmission of an electromagnetic field or alternating current (AC) power, generated through a coil, to a control circuit board.

Conventionally, a coil lead of a wireless charging device is fixed to an apparatus using a separate instrument, which includes, for example, a connector or a solder, and is connected to a control circuit board.

When a separate instrument is not used for a coil lead, the coil lead is fixed and connected to a control circuit board via an accommodation process.

However, when a separate instrument is used, there is a problem in that manufacturing costs are disadvantageously increased and a process of accommodating the coil lead requires a separate manual operation, thus leading to an increase in a defective fraction.

### [Disclosure]

### [Technical Problem]

Embodiments provide a coil block for wireless charging and a method of manufacturing the same.

Embodiments provide a coil block for fixing and connecting a coil lead to a control circuit board without a separate instrument or manual accommodation process and a wireless charging apparatus including the corresponding coil block installed therein.

Further, embodiments provide a coil block for providing a wireless charging apparatus exhibiting ease of assembly of components and high durability and a method of manufacturing the coil block.

It is to be understood that both the foregoing general description and the following detailed description of the embodiments are exemplary and explanatory and are intended to provide further explanation of the embodiments as claimed.

### [Technical Solution]

Embodiments provide a coil block for wireless charging, a wireless charging apparatus with the corresponding coil block installed therein, and a method of manufacturing the coil block and the apparatus.

In one embodiment, a method of manufacturing a coil block for wireless charging includes configuring a shielding block including two lead holes for allowing two lead lines configured on a pattern coil to penetrate the lead holes, allowing the lead lines to penetrate the corresponding lead holes, respectively, to dispose the pattern coil on one surface of the shielding block, and attaching an adhesive member to a remaining surface of the shielding block.

The method may further include dipping-processing a portion of an end of the penetrating lead line.

The method may further include bending the portion of the end of the penetrating lead line prior to the dipping-processing.

An external support wall may be formed on one surface of the shielding block along an external circumference of the shielding block, and the two lead lines may be guided to the two lead holes through an opening configured in one side of the external support wall.

The shielding block may include a center hole, an internal support wall may be formed on the one surface of the shielding block along the center hole, and the pattern coil may be disposed between the external support wall and the internal support wall.

A protrusion including the two lead holes may be formed on the shielding block on an extension line of the opening.

The shielding block may be a sandust block.

The sandust block may be generated by injection-molding molten resin generated by mixing insulated flake powder and insulating resin powder and then performing heat treatment on a resultant mixture.

The shielding block may be a ferrite-based material.

The pattern coil may include an even number of coil layers and the lead lines are formed at the lowermost layer and the uppermost layer, respectively.

In another embodiment, a coil block for wireless charging includes a shielding block including two lead holes, a pattern coil disposed on one surface of the shielding block and including two lead lines penetrating the two lead holes, and an adhesive member attached to a remaining surface of the shielding block

A portion of an end of the penetrating lead line may be subjected to dipping-processing.

The portion of the end of the penetrating lead line may be bent prior to the dipping-processing and the portion of the end of the bent lead line may be subjected to dipping-processing.

The shielding block may include an external support wall formed on the one surface of the shielding block along an external circumference of the shielding block, and an opening formed in one side of the external support wall and configured to guide the two lead lines to the two lead holes.

The shielding block may further include a center hole, and an internal support wall formed on the one surface of the shielding block along the center hole, and the pattern coil may be disposed between the external support wall and the internal support wall.

The shielding block may further include a protrusion including the two lead holes formed therein and the protrusion may be disposed on an extension line of the opening.

The shielding block may be a sandust block.

The sandust block may be generated by injection-molding molten resin generated by mixing insulated flake powder and insulating resin powder and then performing heat treatment on a resultant mixture.

The shielding block may be a ferrite-based material.

The pattern coil may include an even number of coil layers and the lead lines may be formed at the lowermost layer and the uppermost layer, respectively.

In another embodiment, a wireless power transmission apparatus includes a body, a transmission coil block installed in the body and configured to wirelessly transmit power, a transmitter control circuit board connected to the transmission coil block and configured to control power transmission, and a power supply configured to supply power to the transmitter control circuit board, wherein the transmission coil block includes a shielding block including two lead holes, a pattern coil disposed on one surface of the shielding block and including two lead lines penetrating the two lead holes, and an adhesive member attached to a remaining surface of the shielding block.

In another embodiment, a wireless power reception apparatus includes a body, a reception coil block installed in the body and configured to wirelessly receive power, a receiver control circuit board connected to the reception coil block and configured to rectify received alternating current (AC) power and to control power reception, and a load configured to receive the power rectified by the receiver control circuit board, wherein the reception coil block includes a shielding block including two lead holes, a pattern coil disposed on one surface of the shielding block and including two lead lines penetrating the two lead holes, and an adhesive member attached to a remaining surface of the shielding block.

In another embodiment, a coil block for wireless charging includes a shielding block including a lead fixation unit, a pattern coil disposed on one surface of the shielding block and including a lead line disposed on the lead fixation unit, and an adhesive member attached to a remaining surface of the shielding block.

The shielding block may include an external support wall formed on the remaining surface of the shielding block along an external circumference of the shielding block, and an opening formed in one side of the external support wall.

The shielding block may further include a protrusion including the two lead holes formed therein and the protrusion may be disposed on an extension line of the opening.

It is to be understood that both the foregoing general description and the following detailed description of the embodiments are exemplary and explanatory and are intended to provide further explanation of the embodiments as claimed.

### [Advantageous Effects]

The method and apparatus according the disclosure may have the following effects.

The disclosure may advantageously provide a coil block for wireless charging a wireless charging apparatus with the corresponding coil block installed therein, and a method of manufacturing the coil block and the apparatus.

The disclosure may advantageously provide a coil block for fixing a lead line without a separate instrument and a manual accommodation process and for easy connection between a coil and a control circuit board, and a wireless charging apparatus including the corresponding coil block installed therein.

The disclosure may advantageously provide a wireless charging apparatus for ease of assembly and high durability as well as low manufacturing costs.

It will be appreciated by persons skilled in the art that that the effects that could be achieved with the embodiments are not limited to what has been particularly described hereinabove and other advantages of the embodiments will be more clearly understood from the following detailed description taken in conjunction with the accompanying drawings.

### [Description of Drawings]

The accompanying drawings, which are included to provide a further understanding of the disclosure, illustrate embodiments and together with the description serve to explain the principle of the embodiments.

In the drawings:
FIG. 1 is a block diagram for explanation of a wireless charging system according to an embodiment;
FIG. 2 is a perspective view for explanation of an overall structure of a coil block according to an embodiment;
FIG. 3 is an exploded diagram for explanation of a stack structure and an assembly method of a coil block according to an embodiment;
FIG. 4 is an elevation diagram for explanation of an outer appearance of a coil block according to an embodiment;
FIG. 5 is a diagram for explanation of a lead line dipping-processing method according to an embodiment;
FIG. 6 is a flowchart for explanation of a coil block manufacturing method for wireless charging according to an embodiment;
FIG. 7 is a flowchart for explanation of a coil block manufacturing method for wireless charging according to another embodiment; and
FIG. 8 is a diagram for explanation of a wireless charging system using a coil block according to an embodiment.

### [Best Mode]

Hereinafter, devices and various methods, to which embodiments of the disclosure are applied, will be described in more detail with reference to the accompanying drawings. The suffixes "module" and "unit" of elements herein are used for convenience of description and thus can be used interchangeably and do not have any distinguishable meanings or functions.

In description of exemplary embodiments, it will be understood that, when an element is referred to as being "on" or "under" and "before" or "after" another element, the element can be directly on another element or intervening elements may be present. In addition, when an element is referred to as being "on" or "under" another element, this may include the meaning of an upward direction or a downward direction based on one component.

In the following description of the disclosure, for convenience of description, an apparatus for wirelessly transmitting power in a wireless power system may be used interchangeably with a wireless power transmitter, a wireless power transmission apparatus, a wireless power transmission device, a transmission end, a transmitter, a transmission apparatus, a transmission side, a wireless power transmission apparatus, etc. In addition, for convenience of description, an apparatus for wirelessly receiving power from a wireless power transmission apparatus may be used interchangeably with a wireless power reception apparatus, a wireless power receiver, a wireless power reception device, a reception terminal, a reception side, a reception apparatus, a receiver terminal, etc.

A transmitter according to the disclosure may be configured in the form of a pad, a cradle, an access point (AP), a small base station, a stand, a ceiling insert type, a wall-hanging type, or the like. One transmitter may transmit power to a plurality of wireless power reception apparatuses. To this end, a wireless power transmitter may include at least one wireless power transmission element. Here, the wireless power transmission element may use various wireless power transmission standards based on an electromagnetic induction method of charging according to the electromagnetic induction principle that a magnetic field is generated from a coil of a power transmission end and electricity is induced from a coil of a reception end under the influence of the magnetic field. Here, the wireless power transmission element may include wireless charging technology of an electromagnetic induction method defined in wireless power consortium (WPC) and power matters alliance (PMA) which are wireless charging technology standard organizations.

In addition, a wireless power receiver according to an embodiment may include at least one wireless power reception element and may simultaneously and wirelessly receive power from two or more wireless power transmitters. Here, the wireless power reception element may include wireless charging technology of an electromagnetic induction method defined in wireless power consortium (WPC) and power matters alliance (PMA) which are wireless charging technology standard organizations.

A receiver according to the disclosure may be used in a small-size electronic apparatus such as a mobile phone, a smartphone, a laptop computer, a digital broadcasting terminal, a personal digital assistants (PDA), a portable multimedia player (PMP), a navigation system, an MP3 player, an electric toothbrush, a radio frequency identification (RFID) tag, an illumination apparatus, a remote controller, a bobber, or a wearable device including a smart watch, without being limited thereto, and may be any device that includes a wireless power reception element that is rechargeable by a battery.

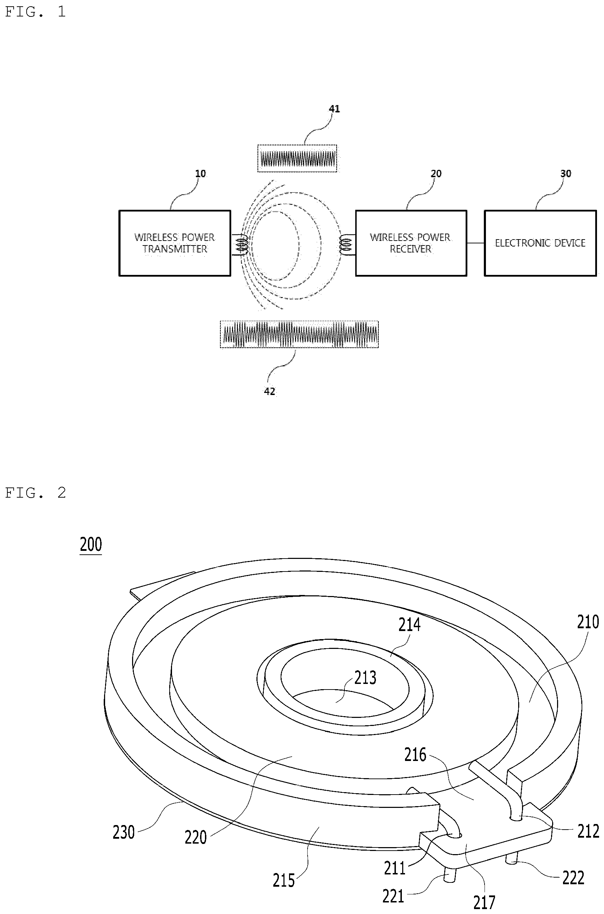

FIG. 1 is a block diagram for explanation of a wireless charging system according to an embodiment.

Referring to FIG. 1, the wireless charging system may broadly include a wireless power transmitter 10 for wirelessly transmitting power, a wireless power receiver 20 for receiving the transmitted power, and an electronic device 30 for supplying the received power.

Here, a load (not shown) that is a rechargeable battery may be installed in the electronic device 30, and received power may be charged in the load of the electronic device 30.

For example, the wireless power transmitter 10 and the wireless power receiver 20 may perform in-band communication for exchanging information using the same frequency band as an operation frequency used in wireless power transmission.

In in-band communication, upon receiving a power signal 41 transmitted from the wireless power transmitter 10, the wireless power receiver 20 may modulate the received power signal and may transmit the modulated signal 42 to the wireless power transmitter 10.

As another example, the wireless power transmitter 10 and the wireless power receiver 20 may also perform out-of-band communication for exchanging information using a separate different frequency band from the operation frequency used in wireless power transmission.

For example, the information exchanged between the wireless power transmitter 10 and the wireless power receiver 20 may include identification information, configuration information, state information, various control information items, and so on.

Communication in the wireless charging system may provide bidirectional communication, but without being limited thereto, and according to another embodiment may provide directional communication such as unidirectional communication or half-duplex communication.

For example, unidirectional communication may be a communication method of transmitting information only to the wireless power transmitter 10 from the wireless power receiver 20, without being limited thereto, and may alternatively be a communication method of transmitting information to the wireless power receiver 20 by the wireless power transmitter 10.

In the half-duplex communication method, bidirectional communication is enabled between the wireless power receiver 20 and the wireless power transmitter 10, but only any one of the wireless power receiver 20 and the wireless power transmitter 10 is capable of transmitting information at any one time point.

The wireless power receiver 20 according to an embodiment may acquire various state information items of the electronic device 30. For example, the state information of the electronic device 30 may include current power usage information, information for identifying a currently running application, CPU usage information, battery charge state information, battery output voltage/current information, and so on, without being limited thereto, and may include any information that is capable of being acquired from the electronic device 30 and being used in wireless power control.

FIG. 2 is a perspective view for explanation of the overall structure of a coil block according to an embodiment.

The coil block according to the disclosure may be installed in a wireless power transmission apparatus or (and) a wireless power reception apparatus.

Referring to FIG. 2, a coil block 200 may include a shield block 210, a pattern coil 220, and an adhesive member 230.

The pattern coil 220 may be disposed on one surface of the shield block 210, and the adhesive member 230 may be disposed on the other surface.

The pattern coil 220 according to an embodiment may be formed as a planar helical coil. In addition, planar helical coils may be stacked to form a multi-layered structure. Here, the helical coil may be formed with any one of a circular form, an oval form, and a pyramid form.

The pattern coil 220 according to an embodiment may be formed in a circuit pattern that is designed via deposition or punching.

In particular, the shield block 210 may include a lead fixation unit for fixing a lead line that extends from the pattern coil 220. For example, a first lead hole 211 and a second lead hole 212 penetrated by two lead lines extending from the pattern coil 220,hereinafter respectively referred to as a first lead line 221 and a second lead line 222, may be formed in one side of the shield block 210.

The shield block 210 may include a central circular hole-hereinafter, for convenience of description, referred to as a "center hole 213"- and an internal support wall 214 that is disposed along an external circumference of the center hole 213 to minimize play-i.e., movement-of the pattern coil 220. For example, a permanent magnet may be disposed in the center hole 213 formed in the shield block 210. As another example, various sensors may be installed in the center hole 213 formed in the shield block 210. For example, the sensor may include at least one of a current sensor, a voltage sensor, an illumination sensor, a capacitance sensor, and a pressure sensor.

The shield block 210 may include an external support wall 215 formed along an external circumference of the shield block, an opening 216 formed in one side of the external support wall 215 to guide the first and second lead lines 221 and 222 in directions towards the first lead hole 211 and the second lead hole 212, respectively, and a protrusion 217 that is formed in an outer direction -e.g., a perpendicular direction- of the external support wall 215 on an extension line of the opening 216 and includes the first lead hole 211 and the second lead hole 212.

The internal support wall 214 and the external support wall 215 may advantageously block transmission of an electromagnetic field of the pattern coil 220 to a control circuit board (not shown) and may also minimize movement and play of the pattern coil 220. Accordingly, a wireless charging apparatus including the coil block 200 installed thereon according to the disclosure may advantageously maintain durability even if the wireless charging apparatus is installed in a place subjected to high impacts and vibrations, such as a vehicle.

In addition, a lead line of the coil block 200 according to the embodiment of FIG. 2 directly penetrates a shield block without a separate terminal connection and soldering process, and thus the coil block 200 may have high durability and an assembly process may be advantageously simplified.

Accordingly, the disclosure may advantageously provide a coil block for fixing a lead line without a separate instrument and a manual accommodation process and for easy connection between a coil and a control circuit board, and a wireless charging apparatus including the corresponding coil block installed therein.

The disclosure may advantageously provide a coil block and a wireless charging apparatus characterized by ease of assembly and high durability as well as reduced manufacturing costs by obviating instruments conventionally required to configure terminals.

In addition, the coil block according to the disclosure may be advantageously installed in a wireless power reception apparatus as well as a wireless power transmission apparatus.

The pattern coil 220 according to an embodiment may include two or more lead lines according to a method of winding and arranging coils. For example, when three coils are arranged to partially overlap, the pattern coil 220 may include six lead lines that extend outwards.

A lead fixation unit according to an embodiment, for example, the lead holes 211 and 212, may be formed in a plural number corresponding to the number of lead lines included in the pattern coil 220. In addition, in consideration of the number of lead lines, an opening and a protrusion may be formed in a plural number.

A lead fixation unit according to an embodiment may be formed in the form of the lead holes 211 and 212 to allow a lead line to penetrate the lead fixation unit, or may have any form for fixing a lead line-e.g., an unevenness structure or a groove form- even if the lead line does not penetrate the lead fixation unit. Accordingly, the lead fixation unit may be formed in a lead groove or form.

In the shield block 210 according to an embodiment, the opening 216 may not be formed on the external support wall 215, but instead a separate lead hole that a lead penetrates may be disposed in the external support wall 215. In this case, the lead line is fixed through the lead fixation unit (the lead hole) disposed on the external support wall 215 and the protrusion 217, and thus, durability may be further increased and a shielding effect may also be further enhanced.

In the shield block 210 according to an embodiment, when the opening 216 is formed in the external support wall 215, the external support wall 215 may not be completely removed, but instead a support wall with a lower height than a surrounding region may be formed or may be only partially penetrated. In this case, a shielding effect may be further enhanced while a lead line is connected to the outside.

In the shield block 210 according to an embodiment, the width of an opening region of the opening 216 may be smaller than the width of the protrusion 217. Accordingly, the protrusion 217 may be more strongly coupled to the shield block 210.

In the shield block 210 according to an embodiment, the opening or the lead fixation unit may be disposed on the internal support wall 214, and thus a lead line may be connected into the shield block 210 and the pattern coil 220. In this case, when the coil block 200 needs to be disposed in a very narrow region, a region occupied by the coil block 200 may be minimized. In addition, the opening or the lead fixation unit may be omitted from the external support wall 215, thereby further enhancing a shielding effect.

In the shield block 210 according to an embodiment, the lead fixation unit may be disposed at a region that does not overlap the pattern coil 220 between the internal support wall 214 and the external support wall 215. In this case, the lead fixation unit may be configured in the form of a lead hole that penetrates a lead line and may be formed to completely surround the lead line. In this case, when the coil block 200 needs to be disposed in a very narrow region, a region occupied by the coil block 200 may be minimized.

In addition, a shielding effect via the internal support wall 214 and the external support wall 215 may be further enhanced.

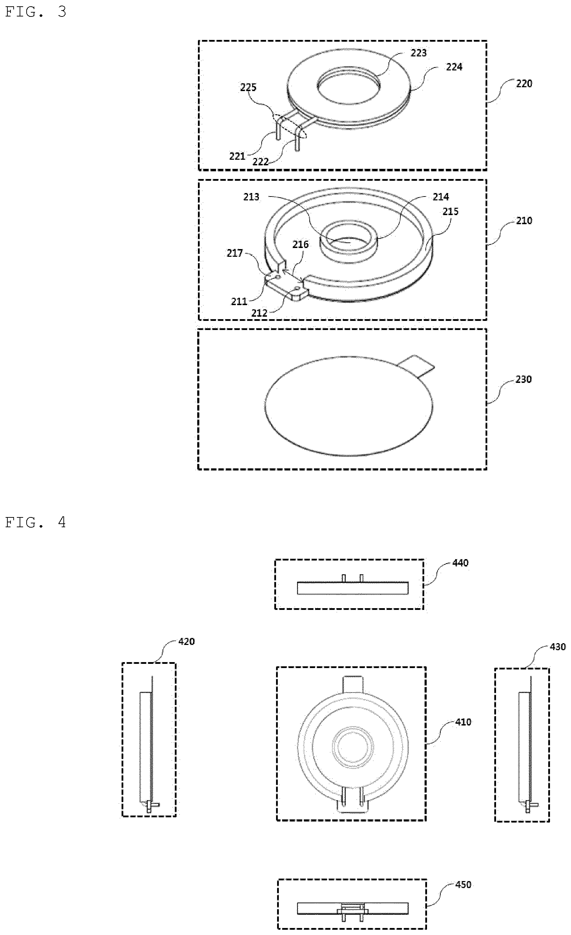

FIG. 3 is an exploded diagram for explanation of a stack structure and an assembly method of a coil block according to an embodiment.

In detail, FIG. 3 is an exploded perspective view of the coil block 200 of FIG. 2.

The shield block 210 that is a component of the coil block 200 according to the present embodiment may include a sandust block, but is not limited thereto and may be formed of a ferrite-based material. Here, the ferrite-based material may be any one of a Ni-Zn-Cu-based material, a Ni-Zn-based material, and a Mn-Zn-based material, but is not limited thereto.

The sandust block may be manufactured by mixing metallic powder and insulating resin powder and performing heat treatment on the mixture to generate molten resin, pouring the generated molten resin in a pre-manufactured casting, and then performing injection molding.

For example, the insulating resin powder may be polyimide resin or phenolic resin. In general, the sandust block has high strength and durability compared with a ferrite-based material, but there is a problem in that the sandust block has difficulty in ensuring excellent insulating properties. To overcome the problem, a process of manufacturing the sandust block may include a process of compression-molding metallic powder to deform the metallic powder to flake powder in the form of a plate, and insulating-e.g., insulating resin coating- a surface of the flake powder with an oxide film formed thereon.

The pattern coil 220 may have a circular coil pattern including an internal circumference 223 and an external circumference 224, and opposite terminals of the coil may include the first lead line 221 and the second lead line 222.

The pattern coil 220 may be configured with a plurality of layers. For example, the pattern coil 220 may include an even number of layers. In this case, the first lead line 221 may be configured at the lowermost layer and the second lead line 222 may be configured at the uppermost layer.

To allow the first lead line 221 and the second lead line 222 to easily penetrate the first lead hole 211 and the second lead hole 212 when the shield block 210 and the pattern coil 220 are coupled to each other, the first lead line 221 and the second lead line 222 may be bent as indicated by reference numeral 225.

Assembly may be performed in such a way that the internal circumference 223 of the pattern coil 220 contacts the internal support wall 214 of the shield block 210, and the first lead line 221 and the second lead line 222 respectively penetrate the first lead hole 211 and the second lead hole 212, which are formed in the protrusion 217, through the opening 216 formed in the external support wall 215 of the shield block 210.

Then, the adhesive member 230 may be attached to another surface of the shield block 210, on which the pattern coil 220 is not disposed.

Accordingly, the disclosure may advantageously provide a coil block and a wireless charging apparatus with ease of assembly and high durability as well as reduced manufacturing costs of the coil block by obviating instruments required to configure terminals.

FIG. 4 is an elevation diagram for explanation of an outer appearance of a coil block according to an embodiment.

In detail, FIG. 4 shows a front view 410, a left side view 420, a right side view 430, an upper view 440, and a lower view 450, for explanation of an outer appearance of the coil block 200 of FIG. 2.

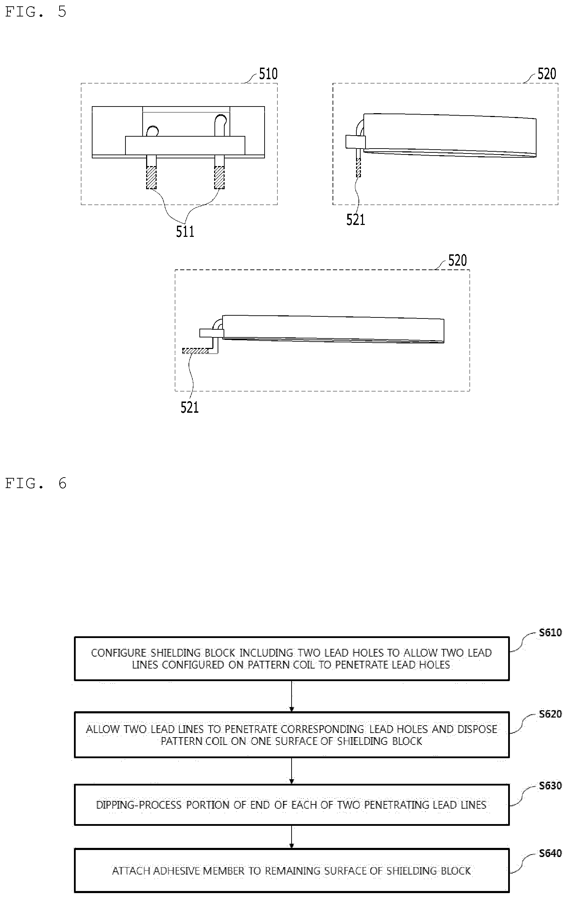

FIG. 5 is a diagram for explanation of a lead line dipping-processing method according to an embodiment.

A coil block manufacturing process according to an embodiment may include dipping-processing a lead line of the coil block 200 for easy connection between the coil block 200 and a control circuit board (not shown).

As indicated by reference numerals 510 and 520, soldering materials 511 and 521-which may be an alloy of, e.g., lead, tin, aluminum, or the like, but is not limited thereto- may be coated on a portion of a surface of an end of the first lead line 221 and the second lead line 222 that penetrate the first lead hole 211 and the second lead hole 212 which are formed in the protrusion 217.

According to another embodiment, as indicated by reference numeral 530, the first lead line 221 and the second lead line 222 that penetrate the first lead hole 211 and the second lead hole 212 may be partially bent, and then a soldering material 531 may be coated on a portion of an end of the bent lead line.

Accordingly, according to the disclosure, lead lines between the coil block 200 and control circuit board (not shown) may be easily connected.

FIG. 6 is a flowchart for explanation of a coil block manufacturing method for wireless charging according to an embodiment.

Referring to FIG. 6, the coil block manufacturing method may include the four operations below.

First operation: A shielding block including two lead holes formed therein to allow two lead lines configured on a pattern coil to penetrate the lead holes may be configured (S610). For example, the two lead holes may be configured on a protrusion formed at one side of the shielding block.

Second operation: The pattern coil may be disposed between an internal support wall and an external support wall, which are formed on one surface of the shielding block, to allow the two lead lines to penetrate the corresponding lead holes (S620).

Third operation: A portion of an end of each of the two penetrating lead lines may be dipping-processed (S630).

Fourth operation: An adhesive member may be attached to the other surface of the shielding block, on which the pattern coil is not disposed (S640). Here, the adhesive member may be a double-sided insulating tape, but is not limited thereto.

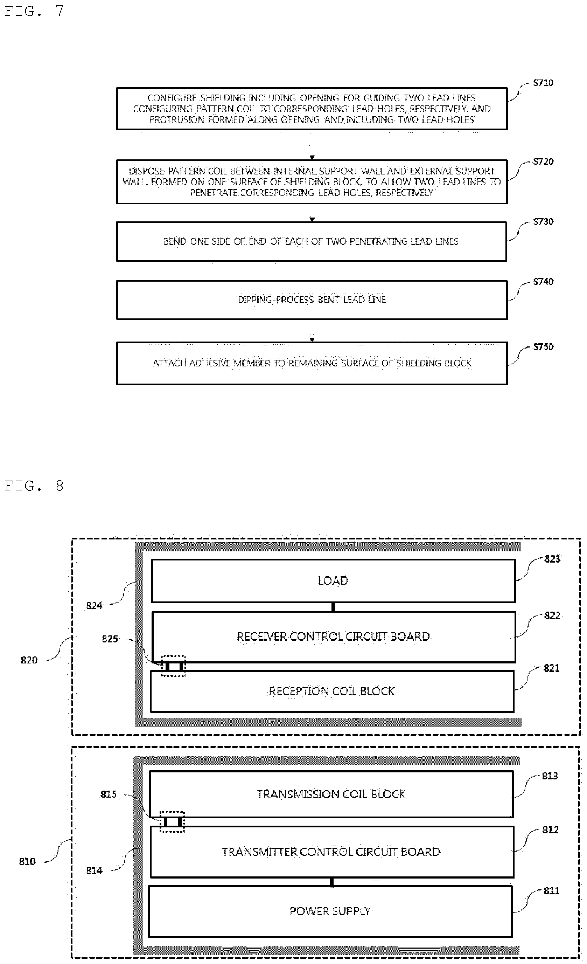

FIG. 7 is a flowchart for explanation of a coil block manufacturing method for wireless charging according to another embodiment.

Referring to FIG. 7, the coil block manufacturing method may include the four operations below.

First operation: A shielding block including an opening for guiding two lead lines configuring a pattern coil to corresponding lead holes, respectively, and a protrusion formed along the opening and including two lead holes may be configured (S710). Here, the opening may be formed in a portion of an external support wall of the shielding block.

Second operation: The pattern coil may be disposed between an internal support wall and the external support wall, which are formed on one surface

of the shielding block, to allow the two lead lines to penetrate corresponding lead holes, respectively (S720).

Third operation: One side of an end of each of the two penetrating lead lines may be bent (S730).

Forth operation: The bent lead line may be dipping-processed (S740).

Fifth operation: An adhesive member may be attached to the other surface of the shielding block, on which the pattern coil is not disposed (S740).

FIG. 8 is a diagram for explanation of a wireless charging system using a coil block according to an embodiment.

Referring to FIG. 8, the wireless charging system may broadly include a wireless power transmission apparatus 810 and a wireless power reception apparatus 820.

The wireless power transmission apparatus 810 may include a power supply 811, a transmitter control circuit board 812 a transmission coil block 813, and a transmitter housing 814 (or a transmitter body).

The transmitter control circuit board 818 may include a power converter for converting direct current (DC) power supplied from the power supply 811 into specific DC power, an inverter for converting the converted DC power into alternating current (AC) power having a specific operation frequency, a modulation/demodulation device for communication with the wireless power reception apparatus 820, a control device for controlling the overall operation of a transmitter-e.g., a microprocessor-, and so on.

The transmitter control circuit board 818 may include a connection terminal for connection of a dipping-processed lead line 815 of the transmission coil block 813.

For a description of a structure of the transmission coil block 813, reference may be made to the above description of FIGS. 2 to 5.

The wireless power reception apparatus 820 may include a reception coil block 821, a receiver control circuit board 822, a load 823, and a receiver housing 824 (or a receiver body).

Here, for a description of the reception coil block 821, reference may be made to the above description of FIGS. 2 to 5.

AC power receiver through the reception coil block 821 may be transmitted to the receiver control circuit board 822 through a lead line 825. To this end, the dipping-processed lead line 825 of the reception coil block 821 may be included at one side of the receiver control circuit board 822.

The receiver control circuit board 822 may include a rectifier for converting received AC power into DC power, a power converter for converting rectified DC power into the specific power required by the load 823, a modulation/demodulation device for communication with the wireless power transmission apparatus 810, a control device for control of the overall operation of a receiver -e.g., a microprocessor-, and so on.

The transmission coil block 813 and the reception coil block 821 according to the present embodiment may be configured using the structure and the manufacturing method illustrated in FIGS. 2 to 7. However, it may be noted that portions of the detailed form and aspects of the configuration of the transmission coil block 813 and the reception coil block 821may be configured differently according to a design purpose of those skilled in the art, the standard and product specifications of the corresponding transmission coil block 813 and reception coil block 821, and so on.

Soft magnetic powder of metal alloy, used to manufacture the sandust according to the disclosure may be prepared by pulverizing ribbon manufactured via fast cooling using a single rolling process that is one of a typical rapidly solidified process (RSP) or may be prepared via high pressure water atomization. As another example, the soft magnetic powder of metal alloy may be acquired by spraying high-pressure inert cooling gas-which includes, e.g., nitrogen (N₂), helium (He), neon (Ne), or argon (Ar)- to freely falling molten metal through a spray nozzle when an alloy source material melted in a furnace freely falls through a nozzle included at one side of a lower end of the furnace to rapidly cool the gas, but this is merely an embodiment, and the soft magnetic powder of metal alloy may be acquired using various other methods.

A chemical additive used for surface insulating processing of the flake powder according to an embodiment may be a silicon (Si)-based material, a calcium (Ca)-based material, or a zinc (Zn)-based material, for example, phosphate, Kenolube, kaolin, talc, magnesium hydroxide Mg(OH)₂, aluminum oxide (Al₂O₃), Zn-stearate, Mg-stearate, or water glass, but is not limited thereto.

Those skilled in the art will appreciate that the disclosure may be carried out in other specific ways than those set forth herein without departing from the spirit and essential characteristics of the disclosure.

It will be apparent to those skilled in the art that various modifications and variations can be made in the disclosure without departing from the spirit or scope of the disclosure. Thus, it is intended that the disclosure cover the modifications and variations of the embodiment provided they come within the scope of the appended claims and their equivalents.

## Claims

1. A method of manufacturing a coil block for wireless charging, the method comprising:
configuring a shielding block including two lead holes for allowing two lead lines configured on a pattern coil to penetrate the lead holes;
allowing the lead lines to penetrate the corresponding lead holes, respectively, to dispose the pattern coil on one surface of the shielding block; and
attaching an adhesive member to a remaining surface of the shielding block,
wherein an external support wall is formed on one surface of the shielding block along an external circumference of the shielding block, the two lead lines are guided to the two lead holes through an opening configured in one side of the external support wall, and a protrusion including the two lead holes is formed on the shielding block on an extension line of the opening.

2. The method of claim 1, further comprising dipping-processing a portion of an end of the penetrating lead line.

3. The method of claim 2, further comprising bending the portion of the end of the penetrating lead line prior to the dipping-processing.

4. The method of claim 1, wherein the shielding block includes a center hole, an internal support wall is formed on the one surface of the shielding block along the center hole, and the pattern coil is disposed between the external support wall and the internal support wall.

5. The method of claim 1, wherein the shielding block is a sandust block.

6. The method of claim 5, wherein the sandust block is generated by injection-molding molten resin generated by mixing insulated flake powder and insulating resin powder and then performing heat treatment on a resultant mixture.

7. The method of claim 1, wherein the shielding block is a ferrite-based material.

8. The method of claim 1, wherein the pattern coil includes an even number of coil layers and the lead lines are formed at the lowermost layer and the uppermost layer, respectively.

9. A coil block for wireless charging comprising:
a shielding block including two lead holes;
a pattern coil disposed on one surface of the shielding block and including two lead lines penetrating the two lead holes; and
an adhesive member attached to a remaining surface of the shielding block,
wherein the shielding block includes:
an external support wall formed on the one surface of the shielding block along an external circumference of the shielding block;
an opening formed in one side of the external support wall and configured to guide the two lead lines to the two lead holes; and
a protrusion including the two lead holes formed therein on an extension line of the opening.

10. The coil block of claim 9, wherein a portion of an end of the penetrating lead line is subjected to dipping-processing.

11. The coil block of claim 10, wherein the portion of the end of the penetrating lead line is bent prior to the dipping-processing and the portion of the end of the bent lead line is subjected to dipping-processing.

12. The coil block of claim 9, wherein the shielding block further includes:
a center hole; and
an internal support wall formed on the one surface of the shielding block along the center hole; and
wherein the pattern coil is disposed between the external support wall and the internal support wall.

13. The coil block of claim 9, wherein the shielding block is a sandust block.

14. The coil block of claim 13, wherein the sandust block is generated by injection-molding molten resin generated by mixing insulated flake powder and insulating resin powder and then performing heat treatment on a resultant mixture.

15. The coil block of claim 9, wherein the shielding block is a ferrite-based material.

16. The coil block of claim 9, wherein the pattern coil includes an even number of coil layers and the lead lines are formed at the lowermost layer and the uppermost layer, respectively.

17. A wireless power transmission apparatus comprising:
a body;
a transmission coil block installed in the body and configured to wirelessly transmit power;
a transmitter control circuit board connected to the transmission coil block and configured to control power transmission; and
a power supply configured to supply power to the transmitter control circuit board,
wherein the transmission coil block includes:
a shielding block including two lead holes;
a pattern coil disposed on one surface of the shielding block and including two lead lines penetrating the two lead holes; and
an adhesive member attached to a remaining surface of the shielding block; and
wherein the shielding block includes:
an external support wall formed on the one surface of the shielding block along an external circumference of the shielding block;
an opening formed in one side of the external support wall and configured to guide the two lead lines to the two lead holes; and
a protrusion including the two lead holes formed therein on an extension line of the opening.

18. A wireless power reception apparatus comprising:
a body;
a reception coil block installed in the body and configured to wirelessly receive power;
a receiver control circuit board connected to the reception coil block and configured to rectify received alternating current (AC) power and to control power reception; and
a load configured to receive the power rectified by the receiver control circuit board;
wherein the reception coil block includes:
a shielding block including two lead holes;
a pattern coil disposed on one surface of the shielding block and including two lead lines penetrating the two lead holes; and
an adhesive member attached to a remaining surface of the shielding block; and
wherein the shielding block includes:
an external support wall formed on the one surface of the shielding block along an external circumference of the shielding block;
an opening formed in one side of the external support wall and configured to guide the two lead lines to the two lead holes; and
a protrusion including the two lead holes formed therein on an extension line of the opening.

19. A coil block for wireless charging, comprising:
a shielding block including a lead fixation unit;
a pattern coil disposed on one surface of the shielding block and including a lead line disposed on the lead fixation unit; and
an adhesive member attached to a remaining surface of the shielding block,
wherein the shielding block includes;
an external support wall formed on the remaining surface of the shielding block along an external circumference of the shielding block;
an opening formed in one side of the external support wall; and
a protrusion including the lead fixation unit formed thereon on an extension line of the opening.
